# EUROPÄISCHE PATENTSCHRIFT

(11) **EP 1 415 397 B1**
(45) Veröffentlichungstag und Bekanntmachung des Hinweises auf die Patenterteilung: **24.10.2012**
(21) Anmeldenummer: 02794585.6
(22) Anmeldetag: 08.08.2002
(51) Int. Cl.: H03K 17/955

(54) **KAPAZITIVER NÄHERUNGSSENSOR ZUM ERFASSEN VON BAUELEMENTGUR-TEN, BAUELEMENTE-ZUFÜRVORRICHTUNG UND VERFAHREN ZUM ERFASSEN VON BAUELEMENTGURTEN**
CAPACITIVE PROXIMITY SENSOR FOR DETECTING COMPONENT BELTS, COMPONENT FEEDING DEVICE AND METHOD FOR DETECTING COMPONENT BELTS
CAPTEUR DE PROXIMITE CAPACITIF DESTINE A DETECTER DES BANDES DE COMPOSANTS, DISPOSITIF D'ALIMENTATION DE COMPOSANTS ET PROCEDE DE DETECTION DE BANDES DE COMPOSANTS

(30) Priorität: 09.08.2001 DE 10139158
(43) Veröffentlichungstag der Anmeldung: 06.05.2004
(73) Patentinhaber: ASM Assembly Systems GmbH & Co. KG, 81379 München (DE)
(72) Erfinder: PALLAS, Dirk, 86899 Landsberg (DE)
(74) Vertreter: Patentanwälte Bals & Vogel
(86) Internationale Anmeldenummer: PCT/EP2002/008905
(87) Internationale Veröffentlichungsnummer: WO 2003/015281

(56) Entgegenhaltungen:
- EP-A1- 0 967 851
- DE-A- 2 363 069
- DE-A- 19 956 630
- US-A- 3 643 706
- US-A- 4 191 894
- US-A- 4 261 440
- US-A- 4 603 581
- CHEN Z ET AL: "DESIGN AND IMPLEMENTATION OF CAPACITIVE PROXIMITY SENSOR USING MICROELECTROMECHANICAL SYSTEMS TECHNOLOGY" IEEE TRANSACTIONS ON INDUSTRIAL ELECTRONICS, IEEE INC. NEW YORK, US, Bd. 45, Nr. 6, 1. Dezember 1998 (1998-12-01), Seiten 886-894, XP000789099 ISSN: 0278-0046

## Beschreibung

Die Erfindung betrifft eine Bauelemente-Zuführvorrichtung mit einer Bauelemente-Transportvorrichtung, von welcher Bauelemente in einer Zuführrichtung an eine Entnahmeposition transportierbar sind, und einem Sensor, von welchem die Anwesenheit oder die Abwesenheit von Objekten erfassbar ist

Ferner betrifft die Erfindung ein Verfahren zum Zuführen von Bauelementen mittels einer Bauelemente-Zuführvorrichtung.

Im Bestückautomaten, beispielsweise für SMD-Bauelemente werden die zu bestückenden Bauelemente mittels Zuführvorrichtungen an Abholpositionen transportiert, von welchen sie z. B. mit einem Revolver-Bestückkopf entnommen und auf eine Leiterplatte bestückt werden können. Häufig sind die Bauelemente in Bauelementgurten angeordnet. Diese sind mit einer Deckfolie versehen, welche in der Zuführvorrichtung zumindest an der Abholposition der Bauelemente abgelöst ist, um die Bauelemente entnehmen zu können. In den Bauelementgurten ist jeweils eine Vielzahl von Bauelementen angeordnet. Jedoch kommt es auch während des Betriebs vor, dass ein Bauelementegurt leer wird und der Zuführvorrichtung ein neuer Bauelementgurt zur Verfügung gestellt werden muss. Hierbei wird der alte Bauelementegurt an seinem Ende mit dem Anfang des neuen Bauelementegurts verbunden, beispielsweise mit einem Spleiß-Element, das ein Blechstreifen sein kann.

Um einen optimalen Bestückprozess zu gewährleisten, ist es erforderlich, die Verbindungsstellen der Bauelementegurte sowie das Gurtende sicher zu erkennen. Hierzu sind bereits Spleiß-Sensoren aus der EP 967 851 oder der EP 859 543 bekannt. Diese Konzepte lehren jeweils einen Spleiß-Sensor, welcher an der Zuführvorrichtung angebracht ist. Jedoch ist der Abstand zwischen dem Spleiß-Sensor und der Abholposition sehr groß, so dass große Ungenauigkeiten bei der Bestimmung der noch in dem Bauelementegurt vorhandenen Bauelemente oder der Bestimmung der Position der Verbindungsstelle der Bauelementegurte auftreten.

Aus der EP 0 967 851 Al ist eine Vorrichtung zur Zuführung elektrischer Bauelemente durch Bänder mit darauf liegenden elektrischen Bauelementen bekannt. Die Vorrichtung weist Zuführeinheit und eine Erfassungseinheit auf, welche den beim Koppeln eines hinteren Endes des von der Zuführeinheit zugeführten ersten Bandes mit dem vorderen Ende eines zweiten Bandes entstehenden Bandverbindungsabschnitt erfasst. Dabei kann die Erfassungseinheit einen kapazitiven Sensor zur Erfassung des Bandverbindungsabschnitts aufweisen.

Aus der Aufsatz "Design and Implementation of Capacitive Proximity Sensor Using Microelectromechanical Systems Technology", von Zhenhai Chen and Ren C. Luo, ISSN 0278-0046 Industrial Electronics, IEEE, von Dezember 1998, sind Grundlagen über kapazitive Näherungssensoren offenbart.

Es ist ferner bekannt, beispielsweise einem Bestückautomaten zuzuführende Bauelemente während des Zuführens durch eine Bauelemente-Zuführvorrichtung hindurch mittels einer Lichtschranke zu erfassen. Hierzu wird beispielsweise in einem Zuführkanal der Bauelemente in der Bauelemente-Zuführvorrichtung in zwei einander gegenüberliegenden Wänden des Zuführkanals jeweils eine Öffnung ausgebildet, so dass durch die Öffnungen hindurch eine optische Messstrecke einer Lichtschranke geführt werden kann. Entlang des Zuführkanals transportierte Bauelemente können hiermit erfasst werden, falls sie die Messstrecke der Lichtschranke unterbrechen. Die Erfassung von Bauelementen mittels einer Lichtschranke weist jedoch mehrere Nachteile auf. So muss bei Verwenden einer Lichtschranke als Detektor für die Bauelemente stets eine optische Messstrecke zur Verfügung gestellt werden. Diese kann einerseits durch Ausbilden von zwei miteinander fluchtenden Öffnungen an einander gegenüberliegenden Wänden des Zuführkanals oder durch Ausbilden einer Öffnung und entsprechendes Anbringen eines Reflexspiegels an einer der Öffnung gegenüberliegenden Wand des Zuführkanals vorgesehen werden.

An der somit erforderlichen mindestens einen Öffnung in dem Zuführkanal können jedoch Probleme während des Transportierens der Bauelemente durch den Zuführkanal auftreten. Beispielsweise können sich Bauelemente am Randbereich der Öffnungen sperren und so einen Weitertransport der Bauelemente in dem Zuführkanal unmöglich machen, während gleichzeitig die Messstrecke der Lichtschranke unterbrochen ist und signalisiert wird, dass Bauelemente weiter transportiert werden.

Insbesondere im Rahmen der zunehmenden Miniaturisierung von Bauelementen ist es schwierig, Bauelemente mittels einer Lichtschranke zu erfassen. Die momentan kleinste Generation von Bauelementen weist nur noch einen Durchmesser von wenigen Zehntel Millimetern auf. Daher müssen die Öffnungen, durch welche hindurch mit der Lichtschranke die Bauelemente in dem Zuführkanal erfasst werden sollen, einen noch kleineren Durchmesser als den Durchmesser der Bauelemente aufweisen. Derartige Öffnungen sind jedoch nur mit großem Aufwand herzustellen.

Es ist daher die Aufgabe der Erfindung, eine Bauelemente-Zuführvorrichtung mit einem Sensor zum Erfassen von Bauelementegurten, sowie ein Verfahren zum Erfassen von Bauelementegurten zu schaffen, bei welchen das Erfassen mit hoher Genauigkeit und kostengünstig durchführbar ist.

Diese Aufgabe wird gelöst durch eine Bauelement-Zuführvorrichtung mit den Merkmalen nach Anspruch 1 sowie ein Verfahren zum Erfassen von Bauelementegurten mit den Merkmalen nach Anspruch 15. Bevorzugte Ausgestaltungen der Erfindung sind in den abhängigen Ansprüchen beansprucht.

Erfindungsgemäß wird auch eine Bauelemente-Zuführvorrichtung geschaffen, welche einen kapazitiven Näherungssensor aufweist. Hierbei ist der Sensor nahe der Entnahmeposition angeordnet. Beispielsweise kann der Sensor in dem Zuführkanal, in welchem die Bauelementgurte geführt werden, integriert werden. Ferner kann eine Auswerte-Einrichtung vorgesehen werden, von welcher das Ausgangssignal des Sensors beispielsweise digital verarbeitet werden kann. Es ist auch möglich, die Auswerte-Einrichtung durch einen in der Bauelemente-Zuführvorrichtung vorhandenen Mikrocomputer zu bilden.

Die Bauelement-Zuführvorrichtung nach der Erfindung kann derart ausgebildet sein, dass die Koppelelemente, welche zum Verbinden von Bauelementgurten verwendet oder geeignet sind, während des Erfassens dieser Koppelelemente mit einem Masseanschluss verbindbar sind. Hierdurch ist eine präzisere Messung möglich.

Der kapazitive Näherungssensor lässt sich kostengünstig und einfach herstellen, da auf einem elektrisch nicht leitenden Substrat, beispielsweise Leiterplattenmaterial, mindestens zwei leitfähige Sensorflächen, beispielsweise durch Ätzen einfach und kostengünstig ausgebildet werden können. Zudem kann der erfindungsgemäße kapazitive Näherungssensor auch mit sehr geringen Abmessungen ausgebildet werden, so dass er in einen Zuführkanal in der Bauelement-Zuführvorrichtung in unmittelbarer Nähe oder direkt an der Abholposition der Bauelemente angeordnet werden kann. Hierdurch kann die Verbindungsstelle zwischen zwei Bauelementgurten in der Nähe der bzw. unmittelbar an der Abholposition erfasst werden. Somit ist eine exakte Bestückung des Gurtendes des entleerten Bauelementegurtes sowie auch des Gurtanfangs des angespleißten Bauelementgurtes möglich. Aufgrund des geringen oder nicht vorhandenen Abstands des Sensors in der Bauelement-Zuführvorrichtung von der Abholposition ist eine hohe Genauigkeit bei der Erfassung gewährleistet.

Erfindungsgemäß ist die Permitivität des Substratmaterials derart gewählt, dass eine optimale Erfassung von Bauelementen und/oder Spleiß-Elementen möglich ist. Hierbei ist für den erfindungsgemäßen Erfolg entscheidend, dass die Permitivität gering gewählt ist, also deutlich geringer als bei handelsüblichem Leiterplattenmaterial mit einer Permitivität Er zwischen 10 und 20.

Bevorzugt weist das Material, aus welchem das Substrat gefertigt ist, eine Dielektrizitätszahl oder Permitivität εᵣ zwischen 3 und 4 auf. Hierdurch wird gewährleistet, dass eine optimale Übertragung der an einer Sensorfläche angelegten elektrischen Signale an die andere Sensorfläche stattfinden kann.

Um den kapazitiven Näherungssensor möglichst flach auszubilden, können die Sensorflächen in einer einzigen Ebene angeordnet sein. Hierdurch ist es noch leichter möglich, den kapazitiven Näherungssensor in einer Bauelemente-Zuführvorrichtung zu integrieren.

Die Sensorflächen sind jeweils mäanderartig oder fingerartig ineinandergreifend ausgebildet, wodurch die Kapazität des kapazitiven Näherungssensors erhöht und somit seine Empfindlichkeit verbessert wird.

Es ist auch möglich, den kapazitiven Näherungssensor zu einer Symmetrieachse symmetrisch auszubilden, wobei eine Sensorfläche sich über den gesamten kapazitiven Näherungssensor erstreckt und noch mindestens zwei weitere Sensorflächen vorgesehen sind, welche bezüglich der Symmetrieachse symmetrisch zueinander angeordnet sind.

Der kapazitive Näherungssensor ist besonders geeignet zum Erfassen von Baulementgurten bzw. von Bauelementen in den Bauelementgurten bzw. von Spleißelementen, welche Bauelementgurte verbinden, da durch die Kombination der geringen Dielektrizitätszahl des Substratmaterials des Sensors und der räumlichen Anordnung der Sensorflächen auf dem Substrat ein Erfassungsbereich für Bauelementgurte im Millimeter-Abstand geschaffen wird. Insbesondere liegt hierbei die Dielektrizitätszahl zwischen 3 und 4 und der Erfassungsabstand zwischen 0,1 und 25 mm.

Der Sensor kann durch Verändern dieser beiden Parameter die Dielektrizitätszahl des Substratmaterials einerseits und räumliche Anordnung der Sensorflächen auf dem Substrat andererseits an die Art der zu erfassenden Bauelementgurte angepasst werden.

Durch eine kamm- bzw. mäanderartige Ausbildung der Sensorflächen auf dem Substrat kann die Kapazität des Sensors maximiert werden und somit die Empfindlichkeit gesteigert werden.

Bei achsensymmetrischer Ausgestaltung des Sensors mit drei Sensorflächen, wobei eine erste Sensorfläche sowohl der zweiten Sensorfläche als auch der dritten Sensorfläche zugewandt angeordnet ist, ist ein differentielles Erfassen der zu erfassenden Objekte, wie beispielsweise Bauelementgurte, Bauelemente und/oder Spleißelemente der Bauelementgurte möglich. Hierdurch können Umwelteinflüsse, wie beispielsweise durch Luftfeuchte, Lufttemperatur und Luftdruck aus dem Messergebnis eliminiert werden. Ferner ist es mit Sensoren, welche zur differentiellen Messung geeignet sind, auch möglich, die Richtung zu erfassen, in welcher die zu erfassenden Objekte den Sensor passieren.

Bei dieser differentiellen Ausbildung kann insbesondere jene Sensorfläche, welche den beiden anderen Sensorflächen zugewandt angeordnet ist, mit einem Masseanschluß verbunden werden, durch welchen ein Referenzpotential an den Sensor angelegt ist, das die Eliminierung der Störgrößen verbessert.

Besonders geeignet ist ein Sensor, welcher in der Längsrichtung der Erfassung im wesentlichen doppelt so lang wie die zu erfassenden Objekte ausgebildet ist.

Erfindungsgemäß wird ferner ein Verfahren zum Erfassen von Bauelementgurten mittels einer Zuführvorrichtung nach der Erfindung geschaffen. Hierbei wird an die Sensorflächen eines erfindungsgemäßen kapazitiven Näherungssensors ein elektrisches Feld angelegt, das angelegte Feld unter Verwenden des kapazitiven Näherungssensors erfaßt und das erfaßte Feld von einer Auswerteeinrichtung analysiert. Anhand des Auswerteergebnisses der Auswerte-Einrichtung wird ermittelt, ob sich ein Objekt zwischen den Sensorflächen befindet.

Hierbei ist es durch Auswerten des erfaßten Feldes möglich, zwischen unterschiedlichen zu erfassenden Objekten, wie beispielsweise Bauelementen, Bauelementgurten, Leerstellen oder Öffnungen in Bauelementgurten und/oder Spleißelementen zum Verbinden zweier Bauelementgurte, zu unterscheiden, da die unterschiedlichen zu erfassenden Objekte auch unterschiedliche Änderungen des erfaßten Feldes im Vergleich zu dem angelegten elektrischen Feld verursachen.

Bei Verwenden eines symmetrisch aufgebauten kapazitiven Näherungssensors ist es ferner möglich, eine differentielle Messung, wie beispielsweise nach dem Anspruch 20, durchzuführen, in der Störungen, wie Veränderungen des Luftdrucks, der Lufttemperaturen oder der Luftfeuchtigkeit, bei dem Analysieren des erfaßten Feldes berücksichtigt werden und somit zu einem genaueren Messergebnis führen können.

Bei dem kapazitiven Sensor werden als Sensoren unterhalb des Zuführkanals zwei oder mehrere Potentialflächen angeordnet. Mittels der Steuervorrichtung werden diesen Potentialflächen stationäre Spannungen oder vorbestimmte Schwingungen aufgeprägt und gleichzeitig die an den Potentialflächen anliegenden Spannungen bzw. Schwingungen nach dem Anlegen bzw. Aufprägen erfasst. Aus dem Unterschied zwischen der jeweils aufgeprägten Spannung bzw. Schwingung und der erfassten Spannung bzw. Schwingung lässt sich ermitteln, ob eine ausreichende Anzahl von Bauelementen in dem Zuführkanal vorhanden sind. Hierzu kann beispielsweise ein vorbestimmter Mindestunterschied zwischen dem aufgeprägten Signal und dem erfassten Signal vorgegeben werden. Es ist auch möglich, Änderungen, insbesondere Kapazitätsänderungen zu erfassen, welche auf Veränderungen der Permitivität in dem Messfeld oder -Raum des Sensors zurückgehen. Dies ist z. B. gegeben, wenn Bauelemente und/oder Spleißelemente das Messfeld des Sensors passieren.

Nach einer erste bevorzugte Ausführungsform der erfindungsgemäßen Bauelemente-Zuführeinrichtung sind an zwei unterschiedlichen Seiten des Zuführkanals jeweils Teilsensoren und angeordnet sind. Hierbei können die unterschiedlichen Seiten des Zuführkanals, einander gegenüberliegende Seiten sowie auch aneinander angrenzende Seiten des Zuführkanals sein. Diese erfindungsgemäße Ausführungsform ist besonders geeignet zur Verwendung einer Mehrzahl von Potentialflächen und als kapazitivem Sensor zum Erfassen von Bauelementen, da bei dieser Anordnung zwischen den Teilsensoren und bzw. den Potentialflächen und eine homogenere Feldverteilung als nach der ersten bevorzugten Ausführungsform der erfindungsgemäßen Bauelemente-Erfassungsvorrichtung vorliegt.

Eine zweite bevorzugte Ausführungsform der erfindungsgemäßen Bauelemente-Erfassungsvorrichtung unterscheidet sich von der zweiten bevorzugten Ausführungsform der erfindungsgemäßen Bauelemente-Erfassungsvorrichtung dadurch, dass zumindest einer der beiden Teilsensoren oder mehrstückig an einer Seite des Zuführkanals ausgebildet ist. Dies ist bei der dritten bevorzugten Ausführungsform der erfindungsgemäßen Bauelemente-Erfassungsvorrichtung durch einen insgesamt vierteiligen Teilsensor realisiert, welcher unter dem Zuführkanal angeordnet ist.

Diese erfindungsgemäße Bauelemente-Zuführvorrichtung weist einen Rahmen auf. An dem Rahmen angeordnet befindet sich eine Zuführschiene, wie oben in Verbindung mit den Ausführungsformen der erfindungsgemäßen Bauelemente-Erfassungsvorrichtung näher erläutert. Die Zuführschiene erstreckt sich im Wesentlichen von einer Entnahmestelle, an welcher entlang des Zuführkanals in der Zuführrichtung transportierte Bauelemente 200 beispielsweise mittels einer Handhabungseinrichtung von der Bauelemente-Zuführvorrichtung entnommen werden können. Die Bauelemente werden hierbei aus einem Magazin angeliefert, welches in einer Magazinaufnahme der erfindungsgemäßen Bauelemente-Zuführvorrichtung angeordnet ist. Bevorzugt ist der Sensor in einem Bereich nahe der Entnahmestelle für die Bauelemente der erfindungsgemäßen Bauelemente-Zuführvorrichtung unter dem Zuführkanal angeordnet.

Allen Ausführungsformen der Erfindung gemeinsam ist, dass zum Erfassen von Bauelementen in dem Zuführkanal einer Bauelemente-Zuführvorrichtung keine Öffnungen in der Zuführschiene oder der Abdeckung der Zuführschiene vorgesehen werden müssen, um die Bauelemente in dem Zuführkanal erfassen zu können. Dies ist insbesondere bei kleinen und kleinsten Bauelementen vorteilhaft, da die Öffnungen für diese Bauelemente nur unter sehr hohem Aufwand mit der erforderlichen Präzision herstellbar sind.

Die Erfindung wird unter Bezugnahme auf die Zeichnung näher erläutert.

In der Zeichnung zeigen:
Figuren 1a und 1b eine erste Ausführungsform des erfindungsgemäßen kapazitiven Näherungssensors,
Figuren 2a und 2b eine zweite Ausführungsform des erfindungsgemäßen kapazitiven Näherungssensors,
Figuren 3a und 3b weitere Ausführungsformen des erfindungsgemäßen kapazitiven Näherungssensors,
Figur 4 eine achsensymmetrische Ausführungsform des erfindungsgemäßen kapazitiven Näherungssensors, und
Figur 5 eine weitere achsensymmetrische Ausführungsform des erfindungsgemäßen kapazitiven Näherungssensors.

Für alle Ausführungsformen der Erfindung gilt, dass auf ein Substrat, wie zum Beispiel FR4 oder Leiterplattenmaterial, zwei oder mehreren Sensorflächen beispielsweise durch Ätzen aufgebracht werden. Das Substrat in Verbindung mit den Sensorflächen bildet einen kapazitiven Sensor bzw. ein kapazitives Koppelelement. Der erfindungsgemäße Sensor ist einfach und kostengünstig herzustellen, leicht zu kontaktieren und läßt sich beispielsweise in einen Gurtkanal eines Zuführmoduls für Stücksysteme an der Ober- und/oder an der Unterseite integrieren oder anbringen. Beispielsweise wird der erfindungsgemäße Sensor zum Erkennen der Spleißstelle zwischen zwei Bauelementgurten ungefähr so breit wie die Transportöffnungen 210 eines Bauelementgurtes ausgebildet, welche zum Transport des Bauelementgurtes mittels eines Stachelrads, dessen Stacheln in die Öffnungen 210 eingreifen, dient. Der Sensor wird beispielsweise unter/oder über der Position dieser Öffnungen 210 in dem Gurtkanal des Zuführmoduls angeordnet. Sobald eine Spleißstelle, an welcher sich ein Spleißelement befindet, den erfindungsgemäßen Sensor passiert, wird entweder eine Datenübertragung zwischen den Sensorflächen des erfindungsgemäßen kapazitiven Näherungssensors gestört oder ein Oszillator beeinflußt, welcher mit den Senderflächen des kapazitiven Näherungssensors verbunden ist.

Zur Auswertung ist eine Auswerte-Einrichtung vorgesehen, welche beispielsweise als diskrete Schaltung aufgebaut sein kann und/oder in einem in dem Zuführmodul vorhandenen oder in dem Bestücksystem vorhandenen Rechner durch Programmierung realisiert sein kann. Bei der Auswertung kommt es grundsätzlich nicht auf die Art des Materials des zu erfassenden Objektes an. Entscheidend ist lediglich, dass das Material des zu erfassenden Objekts eine andere relative Dielektrizitätszahl als das Material des Bauelementgurtes aufweist.

Hierdurch wäre es auch möglich, das Ende eines Bauelementgurtes zu erfassen. Das Erfassen des Gurtendes ist auch möglich, indem der Sensor außerhalb des Zuführmoduls an einer anderen Stelle des Bestücksystems angeordnet und der Gurt an dem Sensor vorbeigeführt wird, also dass das Gurtende erfaßt werden kann.

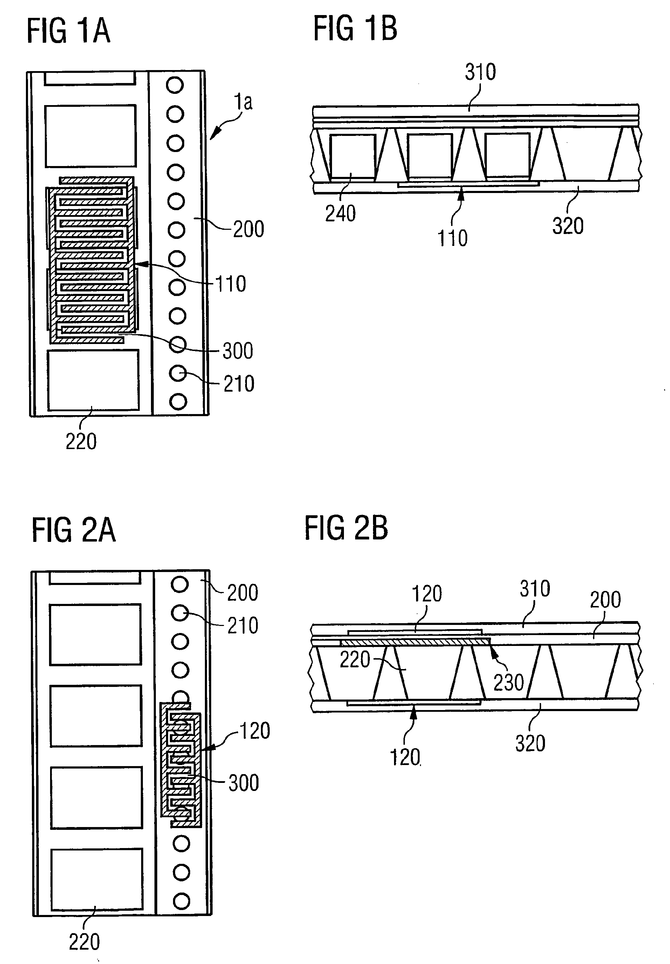

In den Figuren 1a und 1b ist eine bevorzugte Ausführungsform des erfindungsgemäßen kapazitiven Näherungssensors 110 und seine Anordnung relativ zu einem Gurtkanal einer nicht gezeigten Zuführvorrichtung für Bauelementgurte 310, 320 dargestellt. Der Sensor nach der Erfindung 110 weist hierbei zwei Sensorflächen auf, welche jeweils kammartig ausgebildet und mit den Zacken einander zugewandt derart angeordnet sind, dass zwischen den Zacken jeweils ein Abstand verbleibt. In dieser Art und Weise sind die Sensorflächen des Sensors 110 auf einem Substrat (nicht gezeigt) angeordnet. Aus der Figur 1a ist die relative Lage des erfindungsgemäßen Sensors 110 zu einem in dem Gurtkanal 310, 320 des Zuführmoduls transportierbaren Bauelementgurt 200 ersichtlich. Der Bauelementgurt 200 weist Transportöffnungen 210 entlang seiner Längsrichtung auf sowie Bauelementtaschen, in welche Bauelemente 240 aufgenommen sein können.

Wie aus Figur 1b ersichtlich, ist der erfindungsgemäße kapazitive Näherungssensor 110 im Unterteil 320 des Zuführkanals 310, 320 angeordnet. Hierdurch ist eine einfache Erfassung insbesondere von Bauelement 240 in dem Bauelementegurt 200 möglich. Es ist auch möglich, den Sensor 110 oberhalb des Bauelementegurtes 200 an/in dem Zuführkanal 310, 320 anzuordnen.

Aus den Figuren 2a und 2b ist eine Ausführungsform des erfindungsgemäßen kapazitiven Näherungssensors ersichtlich, welche sich zur Erfassung von Spleißelementen 230 eignet, welche zum Verbinden von zwei Bauelementgurten 200 verwendet werden. Hierbei ist der erfindungsgemäße kapazitive Sensor 120 im Bereich der Transportöffnungen 210 des Bauelementgurtes 200 an der Oberseite 310 und/oder an der Unterseite 320 des Gurtkanals eines Bauelemente-Zuführmoduls angeordnet, da auch das Spleißelement 230 an den Transportöffnungen 210 des Bauelementgurtes 200 befestigt wird. Somit ist ein einfaches Erfassen des Spleißelements 230 mittels des erfindungsgemäßen kapazitiven Näherungssensors 120 nach dieser Ausführungsform möglich.

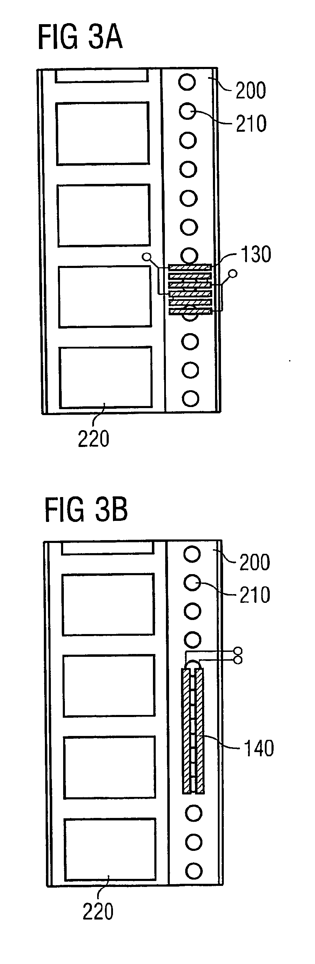

Aus den Figuren 3a und 3b sind weitere Ausgestaltungen der Sensorflächen des erfindungsgemäßen kapazitiven Näherungssensors ersichtlich. Figur 3a zeigt eine Ausgestaltung, bei welcher in Längsrichtung des Bauelementgurtes 200 gesehen aufeinanderfolgend jeweils parallel mehrere Sensorflächen angeordnet sind, wobei diese Sensorflächen des Sensors 130 in der Transportrichtung des Bauelementgurts 200 gesehen jeweils abwechseln mit einer von zwei Anschlußleitungen des Sensors 103 verbunden sind, so dass in der Transportrichtung des Bauelementgurts 200 gesehen jeweils eine oder mehrere quer zu der Transportrichtung angeordnete stabartige Sensorflächen mit abwechselndem Sensoranschluß oder Polung vorgesehen sind.

Nach Figur 3b sind zwei Sensorflächen eines erfindungsgemäßen kapazitiven Näherungssensors 140 vorgesehen, welche sich parallel zueinander in der Transportrichtung des Bauelementgurts 200 über mehrere Transportöffnungen 210 hin erstrecken.

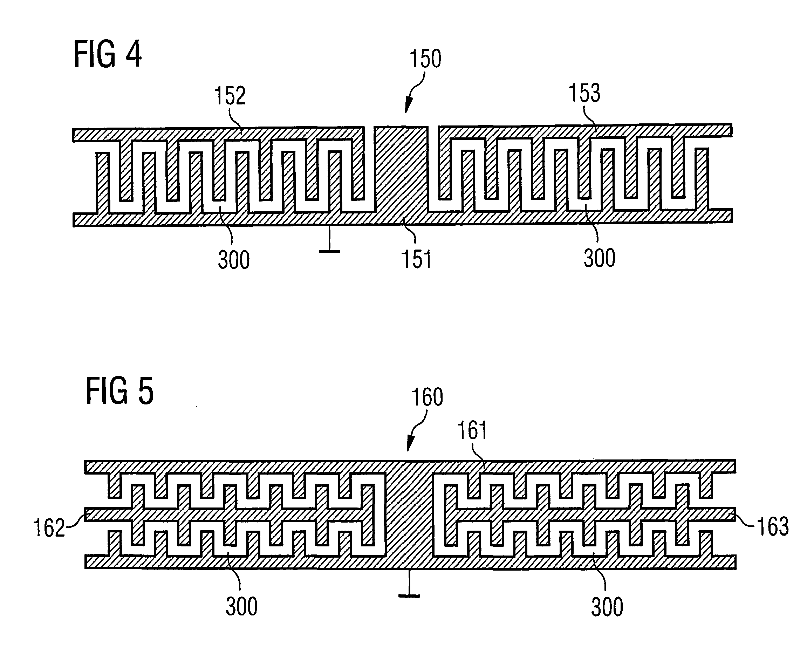

Aus den Figuren 4 und 5 sind jeweils achsensymmetrisch aufgebaute Sensorflächen eines kapazitiven Näherungssensors nach der Erfindung ersichtlich. Die Ausführungsform der Erfindung nach Figur 4 weist einen achsensymmetrischen kapazitiven Näherungssensor 150 auf. Dieser weist eine erste Sensorfläche 151 auf, welche sich in einer ersten Richtung über die annähernd gesamte Länge des Sensors 150 erstreckt. Die erste Sensorfläche 151 ist entlang einer Achse senkrecht der ersten Richtung symmetrisch aufgebaut. Sie weist eine finger- oder kammartige Struktur auf. Dabei weisen die Zacken der Finger im wesentlichen senkrecht zu der ersten Richtung in eine zweite Richtung auf.

Ferner ist der kapazitive Näherungssensor 150 nach Figur 4 mit einer zweiten Sensorfläche 152 und einer dritten Sensorfläche 153 versehen, welche ebenfalls finger- bzw. kammartig ausgebildet und symmetrisch zu der Symmetrieachse des Sensors 150 angeordnet sind, derart, dass die Finger der zweiten Sensorfläche bzw. die Finger der dritten Sensorfläche jenen der ersten Sensorfläche zugewandt angeordnet sind. Hierbei entsteht zwischen den Fingern oder Zacken der ersten Sensorfläche und der zweiten Sensorfläche bzw. der dritten Sensorfläche ein mäanderartiger Zwischenraum. Diese Struktur ist besonders gut zur differentiellen Fassung von Bauelementen und/oder Spleißelementen geeignet. Hierbei kann das Messergebnis noch verbessert werden, indem die erste Sensorfläche 150, wie aus der Figur 4 ersichtlich, mit einem Bezugspotential elektrisch verbunden wird.

Bei der Ausgestaltung des kapazitiven Näherungssensors 160 nach Figur 5 ist eine ähnliche Struktur gewählt wie nach Figur 4. Jedoch weist die erste Sensorfläche 161 des Sensors 160 in und entgegen der ersten Erstreckungsrichtung jeweils zwei finger- bzw. kammartige Fortsätze auf, welche einander zugewandt mit Abstand quer zu der Erstreckungsrichtung angeordnet sind. Innerhalb des Abstandsbereichs der jeweils in oder entgegen der ersten Richtung angeordneten Fortsätze der ersten Sensorfläche 160 ist jeweils eine zweite Sensorfläche 162 und eine dritte Sensorfläche 163 angeordnet. Die zweite Sensorfläche 162 und die dritte Sensorfläche 163 sind zu der Symmetrieachse des Sensors 160 symmetrisch ausgebildet und angeordnet. Sie weisen eine stabartige Struktur mit finger- oder kammartigen Fortsätzen im wesentlichen senkrecht zu der ersten Richtung des kapazitiven Näherungssensors 160 auf, derart, dass zwischen der zweiten Sensorfläche und der ersten Sensorfläche 161 sowie zwischen der dritten Sensorfläche 163 und der ersten Sensorfläche 161 jeweils ein mäanderartiger Zwischenraum verbleibt.

Bei sämtlichen Ausführungsformen der Erfindung ist es vorteilhaft, die Sensorfläche im Wesentlichen in einer Ebene anzuordnen.

## Patentansprüche

1. Bauelemente-Zuführvorrichtung mit einer Bauelemente-Transportvorrichtung, von welcher Bauelemente (240) einer Zuführrichtung an eine Entnahmeposition transportierbar sind, und einen Sensor (110), von welchem die Anwesenheit oder die Abwesenheit von Objekten erfassbar ist, wobei
- der Sensor ein kapazitiver Näherungssensor ist, welcher nahe der Entnahmeposition angeordnet ist,
**dadurch gekennzeichnet, dass**
die Objekte Bauelemente und zum Verbinden von Bauelementgurten geeignete und verwendete Koppelelemente sind oder wobei die Objekte zum Verbinden von Bauelementgurten geeignete und verwendete Koppelelemente (230) sind, welche Koppelelemente leitend und mit einem Bezugspotential verbindbar sind, wobei die Bauelemente-Zuführvorrichtung derart ausgebildet ist, dass die Koppelelemente während des Erfassens der Koppelelemente mit einem Masseanschluss verbindbar sind.

2. Bauelemente-Zuführvorrichtung nach Anspruch 1 wobei der Sensor einstückig mit einem Zuführkanal (310) ausgebildet ist, durch welchen hindurch die Bauelemente zu der Entnahmeposition transportiert werden können.

3. Bauelemente-Zuführvorrichtung nach einem der vorangegangenen Ansprüche, zusätzlich mit einer Auswerte-Einrichtung, von welcher ein Ausgangssignal des Sensors verarbeitet werden kann.

4. Bauelemente-Zuführvorrichtung nach Anspruch 3,
wobei die Auswerte-Einrichtung derart eingerichtet ist, dass eine digitale Filterung des Ausgangssignals durchgeführt wird.

5. Bauelemente-Zuführvorrichtung nach einem der vorangegangenen Ansprüche, mit einem kapazitiven Näherungssensor zum Erfassen von Bauelementgurten, wobei der Sensor mit
- einem elektrisch nichtleitenden Substrat aus einem Material geringer Dielektrizitätszahl, und
- mindestens zwei auf dem Substrat einander zugewandt ausgebildeten elektrisch leitfähigen Sensorflächen (151, 152),
- so dass aufgrund der Dielektrizitätszahl des Substratmaterials und der Anordnung der Sensorflächen (151, 152) auf dem Substrat zu erfassende Bauelementgurte (200) in Millimeter-Abstand erfassbar sind.

6. Bauelemente-Zuführvorrichtung nach Anspruch 5,
wobei die Dielektrizitätszahl des Substratmaterials zwischen 3 und 4 beträgt und der Erfassungsabstand zwischen 0,1 und 25 mm ist.

7. Bauelemente-Zuführvorrichtung nach Anspruch 5 oder 6,
wobei die Sensorflächen (151, 152) in einer einzigen Ebene angeordnet sind.

8. Bauelemente-Zuführvorrichtung nach einem der Ansprüche 5 bis 7,
wobei die Sensorflächen (151, 152) jeweils mäanderartig oder fingerartig ausgebildet sind und die Mäander bzw. Finger der Sensorflächen mit einem vorbestimmten Abstand zueinander ineinandergreifend angeordnet sind.

9. Bauelemente-Zuführvorrichtung nach Anspruch 8, wobei der vorbestimmte Abstand der Sensorflächen zueinander für den gesamten Sensor konstant ist.

10. Bauelemente-Zuführvorrichtung nach einem der Ansprüche 5 bis 7,
- wobei eine erste Sensorfläche (151) eine im Wesentlichen rechteckige Grundfläche mit einem daran in einer ersten Richtung angeordneten Fortsatz aufweist,
- wobei der Fortsatz jeweils eine Mehrzahl von Fingern aufweist, und
- wobei dem Fortsatz zugewandt eine zweite Sensorfläche (152) angeordnet ist, welche derartig mit Fingern versehen ist, dass zwischen der ersten Sensorfläche (151) und der zweiten Sensorfläche (152) ein mäanderartiger Zwischenraum (300) verbleibt.

11. Bauelemente-Zuführvorrichtung nach Anspruch 10,
wobei der Sensor (150) eine zu der rechteckigen Grundfläche bezüglich der ersten Richtung symmetrische Struktur aufweist, so dass insgesamt die erste Sensorfläche (151) mit jeweils einem Fortsatz in bzw. entgegen der ersten Richtung aufweist, von denen jener in der ersten Richtung angeordnete Fortsatz der zweiten Sensorfläche (152) zugewandt ist und der entgegen der ersten Richtung angeordnete Fortsatz einer dritten Sensorfläche (153) zugewandt ist, welche symmetrisch zu der zweiten Sensorfläche (152) ausgebildet und angeordnet ist.

12. Bauelemente-Zuführvorrichtung nach einem der Ansprüche 5 bis 9,
wobei eine erste Sensorfläche (161) eine im Wesentlichen rechteckigen Grundfläche mit zwei daran in einer ersten Richtung angeordneten Fortsätzen aufweist, wobei die Fortsätze jeweils eine Mehrzahl von Fingern aufweisen, welche den Fingern des jeweils anderen Fortsatzes zugewandt angeordnet sind, und wobei zwischen den Fortsätzen eine zweite Sensorfläche (162) angeordnet ist, welche derartig zu der ersten Sensorfläche (161) hin mit Fingern versehen ist, dass zwischen der ersten Sensorfläche (161) und der zweiten Sensorfläche (162) ein mäanderartiger Zwischenraum verbleibt.

13. Bauelemente-Zuführvorrichtung nach Anspruch 12,
wobei der Sensor (160) eine zu der rechteckigen Grundfläche bezüglich der ersten Richtung symmetrische Struktur aufweist, so dass insgesamt die erste Sensorfläche (161) mit jeweils zwei Fortsätzen in bzw. entgegen der ersten Richtung, die zweite Sensorfläche (162) zwischen den beiden in der ersten Richtung angeordneten Fortsätzen und eine dritte, zur zweiten Sensorfläche (162) analoge Sensorfläche (163) zwischen den beiden entgegen der ersten Richtung angeordneten Fortsätzen ausgebildet sind.

14. Bauelemente-Zuführvorrichtung nach Anspruch 11,12 oder 13,
wobei die erste Sensorfläche mit einem Bezugspotential elektrisch verbunden ist.

15. Verfahren zum Erfassen von Objekten, wobei die Objekte Bauelemente und zum Verbinden von Bauelementgurten geeignete und verwendete Koppelelemente sind oder wobei die Objekte zum verbanden von Bauelementgurten geeignete und verwendete Koppelelemente sind, mittels einer Zuführvorrichtung nach einem der vorangegangenen Ansprüchen, bei welchem
- zwischen den Sensorflächen des kapazitiven Näherungssensors ein elektrisches Feld angelegt wird,
- das angelegte Feld unter Verwenden des kapazitiven Näherungssensors erfasst wird,
- das erfasste Feld von einer Auswerte-Einrichtung analysiert wird, und
- aus dem analysierten Feld bestimmt wird, ob sich ein zu erfassendes Objekt zwischen den Sensorflächen befindet, wobei die Koppelelemente während des Erfassens der Koppelelemente mit einem Masseanschluss verbunden werden.

16. Verfahren nach Anspruch 15, bei welchem
- als zu erfassendes Objekt ein in einem Bauelementgurt angeordnetes Bauelement und/oder ein Spleißstreifen zum Verbinden zweier Bauelementegurte erfasst wird.

17. Verfahren nach Anspruch 15 oder 16, bei welchem mittels eines kapazitiven Näherungssensors nach Anspruch 11,13 oder 14
- ein erstes, zwischen der ersten Sensorfläche und der zweiten Sensorfläche erfasstes Feld und ein zweites, zwischen der ersten Sensorfläche und der dritten Sensorfläche erfasstes Feld miteinander verglichen werden, um durch Umgebungsbedingungen hervorgerufene Störungen des zwischen den Sensorflächen angelegten Felds zu ermitteln, und
- die ermittelten Störungen bei dem Analysieren des erfassten Felds berücksichtigt werden.

## Claims

1. A component feeding device with a component transport device, by means of which components (240) can be transported in a feeding direction to a removal position, and a sensor (110), by means of which the presence or the absence of objects can be detected, wherein
- the sensor is a capacitive proximity sensor which is disposed close to the removal position,
**characterized in that**
the objects are components and coupling elements suitable and used for connecting component belts or wherein the objects are coupling elements (230) suitable and used for connecting component belts, which coupling elements can be connected in a conducting manner and with a reference potential, wherein the component feeding device is constructed such that the coupling elements can be connected to aground connection the detection of the coupling elements.

2. The component feeding device according to claim 1, wherein the sensor is constructed in one piece with a feeding channel (310), through which the components can be transported to the removal position.

3. The component feeding device according to any one of the preceding claims, additionally with an evaluation device by means of which an output signal of the sensor can be processed.

4. The component feeding device according to claim 3, wherein the evaluation device is set up in such a way that a digital filtering of the output signal is carried out.

5. The component feeding device according to any one of the preceding claims, with a capacitive proximity sensor for detecting component belts, wherein the sensor is provided with
- an electrically non-conductive substrate made of a material having a low dielectric constant, and
- at least two electrically conductive sensor surfaces (151, 152) which are arranged opposite one another on the substrate,
- so that component belts (200) to be detected on the substrate can be detected in the millimeter range as a result of the dielectric constant of the substrate material and the arrangement of the sensor surfaces (151, 152).

6. The component feeding device according to claim 5, wherein the dielectric constant of the substrate material amounts to between 3 and 4 and the detection distance is between 0.1 and 25 mm.

7. The component feeding device according to claim 5 or 6, wherein the sensor surfaces (151, 152) are disposed in a single plane.

8. The component feeding device according to any one of claims 5 to 7, wherein the sensor surfaces (151, 152) are each constructed meander-like or finger-like and the meanders or fingers of the sensor surfaces are disposed engaging into one another at a predetermined distance from one another.

9. The component feeding device according to claim 8, wherein the predetermined distance of the sensor surfaces from one another is constant for the entire sensor.

10. The component feeding device according to any one of claims 5 to 7,
- wherein a first sensor surface (151) comprises an essentially rectangular base area with an extension disposed thereon in a first direction,
- wherein the extension comprises in each case a plurality of fingers, and
- wherein a second sensor surface (152) is disposed facing the extension, said second sensor surface being provided with fingers in such a way that a meandering intermediate space (300) remains between the first sensor surface (151) and the second sensor surface (152).

11. The component feeding device according to claim 10, wherein the sensor (150) comprises a structure symmetrical with the rectangular base area in respect of the first direction, so that overall the first sensor surface (151) comprises respectively an extension in and opposite to the first direction, whereof the extension disposed in the first direction is facing the second sensor surface (152) and the extension disposed opposite to the first direction is facing a third sensor surface (153), which is constituted and disposed symmetrical with the second sensor surface (152).

12. The component feeding device according to any one of claims 5 to 9, wherein a first sensor surface (161) comprises an essentially rectangular base area with two extensions disposed thereon in a first direction, wherein the extensions each comprise a plurality of fingers, which are disposed facing the fingers of the respective other extension, and wherein there is disposed between the extensions a second sensor surface (162) which is provided with fingers towards the first sensor surface (161), in such a way that a meandering intermediate space remains between the first sensor surface (161) and the second sensor surface (162).

13. The component feeding device according to claim 12, wherein the sensor (160) comprises a structure symmetrical with the rectangular base area in respect of the first direction, so that overall the first sensor surface (161) with in each case two extensions in and opposite to the first direction, the second sensor surface (162) between the two extensions disposed in the first direction and a third sensor surface (163) analogous to the second sensor surface (162) are formed between the two extensions disposed opposite to the first direction.

14. The component feeding device according to claim 11, 12 or 13, wherein the first sensor surface is electrically connected to a reference potential.

15. A method for detecting objects, wherein the objects are components and coupling elements suitable and used for connecting component belts or wherein the objects are coupling elements suitable and used for connecting component belts, by means of a feeding device according to any one of the preceding claims, wherein
- an electric field is applied between the sensor surfaces of the capacitive proximity sensor,
- the applied field is detected using the capacitive proximity sensor,
- the detected field is analyzed by an evaluation device, and
- it is determined from the analyzed field whether an object to be detected is present between the sensor surfaces, wherein the coupling elements are connected to a ground connection during the detection of the coupling elements.

16. The method according to claim 15, wherein
- as the object to be detected, a component disposed in a component belt and/or a splice strip for connecting two component belts is detected.

17. The method according to claim 15 or 16, wherein, by means of a capacitive proximity sensor according to claim 11, 13 or 14,
- a first field detected between the first sensor surface and the second sensor surface and a second field detected between the first sensor surface and the third sensor surface are compared with one another in order to ascertain disturbances of the field applied between the sensor surfaces caused by ambient conditions, and
- the ascertain disturbances are taken into account when the detected field is analyzed.

## Revendications

1. Dispositif d'alimentation de composants comprenant un dispositif de transport de composants, depuis lequel des composants (240) peuvent être transportés dans une direction d'alimentation à une position de prélèvement, et un capteur (110) apte à détecter la présence ou l'absence d'objets, dans lequel
- le capteur est un capteur de proximité capacitif qui est disposé près de la position de prélèvement,
**caractérisé en ce que**
les objets sont des composants et des éléments de couplage appropriés et utilisés pour assembler des bandes de composants ou les objets sont des éléments de couplage (230) appropriés et utilisés pour assembler des bandes de composants, lesquels éléments de couplage peuvent être reliés de manière conductrice et à un potentiel de référence, le dispositif d'alimentation de composants étant réalisé de façon que les éléments de couplage puissent être reliés à une connexion de masse pendant la détection des éléments de couplage.

2. Dispositif d'alimentation de composants selon la revendication 1,
dans lequel le capteur est réalisé d'une seule pièce avec un canal d'alimentation (310) à travers lequel les composants peuvent être transportés vers la position de prélèvement.

3. Dispositif d'alimentation de composants selon une des revendications précédentes, comprenant en plus un dispositif d'évaluation apte à traiter un signal de sortie du capteur.

4. Dispositif d'alimentation de composants selon la revendication 3,
dans lequel le dispositif d'évaluation est conçu de façon qu'un filtrage numérique du signal de sortie soit effectué.

5. Dispositif d'alimentation de composants selon une des revendications précédentes, comprenant un capteur de proximité capacitif pour la détection de bandes de composants, le capteur étant composé
- d'un substrat électriquement non conducteur dans un matériau de faible constante diélectrique et
- d'au moins deux surfaces de détection (151, 152) électriquement conductrices tournées l'une vers l'autre sur le substrat,
- de sorte qu'en raison de la constante diélectrique du matériau du substrat et de la disposition des surfaces de détection (151, 152) sur le substrat, des bandes de composants (200) à détecter sont détectables à intervalle millimétrique.

6. Dispositif d'alimentation de composants selon la revendication 5,
dans lequel la constante diélectrique du matériau du substrat est comprise entre 3 et 4 et l'intervalle de détection entre 0,1 et 25 mm.

7. Dispositif d'alimentation de composants selon la revendication 5 ou 6,
dans lequel les surfaces de détection (151, 152) sont disposées dans un seul plan.

8. Dispositif d'alimentation de composants selon une des revendications 5 à 7,
dans lequel les surfaces de détection (151, 152) sont réalisées en forme de méandre ou de doigt et les méandres ou les doigts des surfaces de détection sont disposés de manière imbriquée à une distance prédéterminée l'une de l'autre.

9. Dispositif d'alimentation de composants selon la revendication 8,
dans lequel la distance prédéterminée des surfaces de détection entre elles est constante pour tout le capteur.

10. Dispositif d'alimentation de composants selon une des revendications 5 à 7,
- dans lequel une première surface de détection (151) présente une surface de base sensiblement rectangulaire avec un prolongement disposé sur celle-ci dans une première direction,
- dans lequel le prolongement présente une pluralité de doigts, et
- dans lequel est disposée une deuxième surface de détection (152) tournée vers le prolongement, laquelle est pourvue de doigts de telle façon qu'il reste un espace en forme de méandre entre la première surface de détection (151) et la deuxième surface de détection (152).

11. Dispositif d'alimentation de composants selon la revendication 10,
dans lequel le capteur (150) présente une structure symétrique par rapport à la surface de base rectangulaire relativement à la première direction, de sorte qu'au total la première surface de détection (151) présente un prolongement dans la première direction et un prolongement à l'encontre de celle-ci, dont celui disposé dans la première direction est tourné vers la deuxième surface de détection (152) et celui disposé à l'encontre de la première direction est tourné vers une troisième surface de détection (153) qui est réalisée et disposée symétriquement par rapport à la deuxième surface de détection (152).

12. Dispositif d'alimentation de composants selon une des revendications 5 à 9,
dans lequel une première surface de détection (161) présente une surface de base sensiblement rectangulaire avec deux prolongements disposés sur celle-ci dans une première direction, les prolongements présentant chacun une pluralité de doigts, lesquels sont tournés vers les doigts de l'autre prolongement respectif, et dans lequel une deuxième surface de détection (162) est disposée entre les prolongements, laquelle est pourvue de doigts en direction de la première surface de détection (161) de telle façon qu'il reste un espace en forme de méandre entre la première surface de détection (161) et la deuxième surface de détection (162).

13. Dispositif d'alimentation de composants selon la revendication 12,
dans lequel le capteur (160) présente une structure symétrique par rapport à la surface de base rectangulaire relativement à la première direction, de sorte qu'au total la première surface de détection (161) est réalisée avec deux prolongements, respectivement dans la première direction et à l'encontre de celle-ci, la deuxième surface de détection (162) entre les deux prolongements disposés dans la première direction et une troisième surface de détection (163), analogue à la deuxième surface de détection (162), entre les deux prolongements disposés à l'encontre de la première direction.

14. Dispositif d'alimentation de composants selon la revendication 11, 12 ou 13,
dans lequel la première surface de détection est reliée électriquement à un potentiel de référence.

15. Procédé de détection d'objets, dans lequel les objets sont des composants et des éléments de couplage appropriés et utilisés pour assembler des bandes de composants ou dans lequel les objets sont des éléments de couplage appropriés et utilisés pour assembler des bandes de composants, au moyen d'un dispositif d'alimentation selon une des revendications précédentes, dans lequel
- un champ électrique est appliqué entre les surfaces de détection du capteur de proximité capacitif,
- le champ appliqué est détecté en utilisant le capteur de proximité capacitif,
- le champ détecté est analysé par un dispositif d'évaluation, et
- il est déterminé, à partir du champ analysé, si un objet à détecter se trouve entre les surfaces de détection, les éléments de couplage étant reliés à une connexion de masse pendant la détection des éléments de couplage.

16. Procédé selon la revendication 15, dans lequel
- un composant disposé dans une bande de composants et/ou un ruban d'épissage servant à assembler deux bandes de composants est détecté en tant qu'objet à détecter.

17. Procédé selon la revendication 15 ou 16, dans lequel on utilise un capteur de proximité capacitif selon la revendication 11, 13 ou 14 pour
- comparer entre eux un premier champ détecté entre la première surface de détection et la deuxième surface de détection et un deuxième champ détecté entre la première surface de détection et la troisième surface de détection pour déterminer des perturbations du champ appliqué entre les surfaces de détection qui sont provoquées par les conditions d'environnement, et
- tenir compte des perturbations déterminées dans l'analyse du champ détecté.
